# EUROPÄISCHE PATENTSCHRIFT

(11) **EP 3 631 978 B1**
(45) Veröffentlichungstag und Bekanntmachung des Hinweises auf die Patenterteilung: **31.07.2024**
(21) Anmeldenummer: 18732649.1
(22) Anmeldetag: 15.05.2018
(51) Int. Cl.: H03F 1/26, H03F 1/30, H03F 1/32, H03F 3/45, H03F 1/42, H03F 3/08

(54) **TRANSIMPEDANZVERSTÄRKER-SCHALTUNG**
TRANSIMPEDANCE AMPLIFIER CIRCUIT
CIRCUIT À AMPLIFICATEUR À TRANSIMPÉDANCE

(30) Priorität: 23.05.2017 DE 102017111197
(43) Veröffentlichungstag der Anmeldung: 08.04.2020
(73) Patentinhaber: Sicoya GmbH, 12489 Berlin (DE)
(72) Erfinder: SCHEYTT, Johann Christoph, 46284 Dorsten (DE); GUDYRIEV, Sergiy, 33104 Paderborn (DE)
(74) Vertreter: Fischer, Uwe
(86) Internationale Anmeldenummer: PCT/DE2018/200048
(87) Internationale Veröffentlichungsnummer: WO 2018/215030

(56) Entgegenhaltungen:
- EP-A1- 0 556 000
- US-A- 5 130 667
- US-A- 5 345 073
- US-A1- 2015 086 221
- ZAND B ET AL: "Transimpedance amplifier with differential photodiode current sensing", PROCEEDINGS OF THE 1999 IEEE INTERNATIONAL SYMPOSIUM ON CIRCUITS AND SYSTEMS / ISCAS '99, MAY 30 - JUNE 2, 1999, ORLANDO, FLORIDA, IEEE SERVICE CENTER, PISCATAWAY, NJ, vol. 2, 30 May 1999 (1999-05-30), pages 11 - 624, XP010341419, ISBN: 978-0-7803-5471-5, DOI: 10.1109/ISCAS.1999.780842
- ZAND B ET AL: "Transimpedance amplifier with differential photodiode current sensing", PROCEEDINGS OF THE 1999 IEEE INTERNATIONAL SYMPOSIUM ON CIRCUITS AND SYSTEMS / ISCAS '99, MAY 30 - JUNE 2, 1999, ORLANDO, FLORIDA, IEEE SERVICE CENTER, PISCATAWAY, NJ, vol. 2, 30 May 1999 (1999-05-30), pages 11 - 624, XP010341419, ISBN: 978-0-7803-5471-5, DOI: 10.1109/ISCAS.1999.780842
- ELI BLOCK: "An InP Based Broadband Differential Transimpedance Amplifier for 40Gbs DPSK Photoreceivers", 2 February 2011 (2011-02-02), XP055500684, Retrieved from the Internet <URL:http://webee.technion.ac.il/labs/projects/HighSpeedElectronics/Publications/Eli_Bloch_Thesis.pdf> [retrieved on 20180820]

## Beschreibung

Die Erfindung betrifft eine Schaltung enthaltend einen Transimpedanzverstärker zur Umsetzung zweier Eingangsströme in zwei Ausgangsspannungen mit einem ersten Verstärkerteil enthaltend einen ersten Eingang, an dem eine erste Eingangsspannung anliegt und in den ein erster Eingangsstrom fließt, und mit einem zweiten Verstärkerteil enthaltend einen zweiten Eingang, an dem eine zweite Eingangsspannung anliegt und in den ein zweiter Eingangsstrom fließt.

Transimpedanzverstärker werden insbesondere dazu eingesetzt, um ein Eingangsstromsignal in ein Ausgangsspannungssignal umzuwandeln. Das Eingangsstromsignal kann beispielsweise der Strom einer Fotodiode sein. Der Transimpedanzverstärker empfängt das aus der Fotodiode ausgegebene Stromsignal, wandelt das Stromsignal in ein entsprechendes Spannungssignal um und gibt das Spannungssignal aus. Das Spannungssignal kann gegebenenfalls durch einen Verstärker verstärkt werden.

Aus der US 5 345 073 A ist eine Schaltung mit einem Transimpedanzverstärker bekannt, an dessen Eingang eine Fotodiode symmetrisch angeschlossen ist. Hierbei sind eine Kathode und eine Anode der Fotodiode direkt mit dem Eingang des Transimpedanzverstärkers verbunden. Der Transimpedanzverstärker umfasst zwei parallele Stromzweige, in denen jeweils eine Anzahl von Transistoren zur Verstärkung angeordnet ist. Vorteilhaft an der Schaltung ist, dass die Fotodiode direkt, d.h. ohne Koppelkondensatoren an den Verstärkereingang angeschlossen ist, weil dadurch keine zusätzlichen Bauelemente im Signalpfad liegen, wodurch das Hochfrequenzverhalten und Rauschen verbessert, sowie Kosten reduziert werden. Die Fotodiode ist symmetrisch angeschlossen, wodurch zum einen der Differenzbetrieb der Fotodiode ermöglicht und somit zum einen die Gleichtaktunterdrückung verbessert wird und zum anderen sowohl der Strom der Anode als auch der Strom der Kathode der Diode als Eingangsströme des Verstärkers genutzt werden können. Die Fotodiode kann mit geeigneten Arbeitspunktspannungen vorgespannt werden. Nachteilig an der bekannten Schaltung des Transimpedanzverstärkers ist, dass an seinem Eingang zusätzliche Verstärker (Transistoren und Stromquellentransistoren) benötigt werden, was die Schaltung komplexer macht und das Rauschverhalten verschlechtert. Ein weiterer Nachteil ist, dass der zusätzliche Verstärker am Eingang eine Erhöhung der Versorgungsspannung um mindestens zwei Kollektor-Emitter-Spannungen (nämlich Kollektor-Emitter-Spannung eines Stromquellentransistors und Kollektor-Emitter-Spannung eines Transistors in Basisschaltung) zuzüglich der Arbeitspunktspannung der Diode erforderlich macht.

Die Druckschrift "Transimpedance amplifier with differential photodiode current sensing" (Zand B; Phang K; Johns D A, Proceedings of the 1999 IEEE International Symposium on Circuits and Systems / ISCAS '99, May 30 - June 2, 1999, Orlando, Florida, IEEE Service Center, Piscataway, NJ, Vol:2, Page(s):11-624 - 11-627) offenbart einen Transimpedanzverstärker mit zwei Verstärkerteilen, die an eine gemeinsame Versorgungsspannung angeschlossen sind.

Die europäische Offenlegungsschrift EP 0 556 000 A1 offenbart einen Differenzverstärker für ein optisches Speichersystem mit einem Fotodiodendetektor, wobei der Differenzverstärker Eingänge zum Empfangen eines Differenzeingangsstroms von der Fotodiode und Ausgänge zum Bereitstellen eines entsprechenden Differenzausgangsspannungssignals aufweist. Der Differenzverstärker ist gekennzeichnet durch eine Vorwärts-Transimpedanzverstärkung und eine Diodenvorspannungsstufe, die die Eingänge und die Ausgänge verbindet.

Aufgabe der vorliegenden Erfindung ist es, eine Schaltung mit einem Transimpedanzverstärker, an dem eingangsseitig symmetrisch eine Fotodiode ohne Koppelkondensatoren angeschlossen ist und die es ermöglicht eine Arbeitspunktspannung der Fotodiode einzustellen, derart weiterzubilden, dass das Rauschen, die Versorgungsspannung und die Schaltungskomplexität verringert werden.

Zur Lösung dieser Aufgabe sind die Merkmale des Patentanspruchs 1 vorgesehen..

Nach der Erfindung ist ein Transimpedanzverstärker vorgesehen, der über ein vergleichsweise geringeres Rauschverhalten, eine niedrige Versorgungsspannung und eine geringere Schaltungskomplexität verfügt. Er kann vielseitig eingesetzt werden, insbesondere zur rauscharmen Verstärkung von Stromsignalen von Detektoren oder Sensoren im Hochfrequenzbereich, z.B. Fotodetektoren, Hall-Sensoren, Drucksensoren oder Temperatursensoren.

Nach einer bevorzugten Ausführungsform der Erfindung ist an einen Transimpedanzverstärker eingangsseitig symmetrisch eine Fotodiode angeschlossen, wobei Anode und Kathode der Fotodiode direkt an Eingangsanschlüssen des Transimpedanzverstärkers angeschlossen sind. Am Eingang des Transimpedanzverstärkers sind keine zusätzlichen Bauelemente, wie Kondensatoren und Widerstände, erforderlich, die die Bandbreite und die Empfindlichkeit bzw. das Rauschen des Transimpedanzverstärkers verschlechtern würden. Die Erfindung ermöglicht auf kosteneffiziente Weise die Bereitstellung eines Transimpedanzverstärkers. Der Transimpedanzverstärker enthält ein Arbeitspunktanpassungsteil, mittels dessen eine Anpassung z.B. an eine Sperrspannung der Fotodiode ermöglicht wird. Vorteilhaft können hierdurch einfach unterschiedliche Fotodiodentypen am Eingang des Transimpedanzverstärkers angeschlossen werden bzw. der Arbeitspunkt der Fotodiode so eingestellt werden, dass der Dunkelstrom minimiert oder die Bandbreite maximiert werden. Da eingangsseitig des Transimpedanzverstärkers keine zusätzlichen Bauelemente angeordnet sind, kann das Rauschen des Transimpedanzverstärkers gering und die Bandbreite hoch gehalten werden.

Nach einer Weiterbildung der Erfindung ist ausgangsseitig des Transimpedanzverstärkers eine Differenz-Spannungsausgleichseinheit vorgesehen, mittels dessen eine Gleichspannungsdifferenz zwischen einem positiven Ausgangsanschluss und einem negativen Ausgangsanschluss des Transimpedanzverstärkers auf Null reduziert werden kann.

Nach einer bevorzugten Ausführungsform der Erfindung ist die Differenz-Spannungsausgleichseinheit durch einen passiven Hochpassfilter gebildet. Dieser besteht aus Kapazitäten, die mit den Ausgangsanschlüssen verbunden sind. Vorteilhaft können hierdurch die Spannungssignalverläufe an dem positiven Ausgangsanschluss und an dem negativen Ausgangsanschluss auf ein gemeinsames Gleichspannungsniveau gesetzt werden.

Nach einer Weiterbildung der Erfindung ist die Differenz-Spannungsausgleichseinheit durch ein Rückkopplungsschaltungs-Teil gebildet. Dieses umfasst einen Tiefpassfilter, einen Fehlerkorrekturverstärker und ein Transistorschaltungs-Teil, so dass eingangsseitig des Transimpedanzverstärkers ein Differenzstrom fließt, der sich automatisch so einstellt, dass die Spannungssignalverläufe an dem positiven Ausgangsanschluss und an dem negativen Ausgangsanschluss auf ein gemeinsames Gleichspannungsniveau gesetzt werden . Im Vergleich zu der vorgenannten Weiterbildung kann hierdurch zusätzlich ein RSSI (Received Signal Strength Indicator), Burst Mode Operationen und Kanalausfallüberwachung implementiert werden.

Die Erfindung ermöglicht insbesondere einen geringen Versorgungsspannungsdurchgriff (hohe Power Supply Rejection Ratio, PSRR), eine geringe Gleichtaktverstärkung (common-mode gain) bei gleichzeitig hoher Differenzverstärkung (differential-mode gain) aufgrund der volldifferenziellen Eingangspegelstandes und des volldifferenziellen Aufbaus des Transimpedanzverstärkers. Zusätzliche parasitäre Kapazitäten sind nicht vorhanden, da am Eingang des Transimpedanzverstärkers die Fotodiode direkt an den Eingangsanschlüssen angeschlossen ist. Die Erfindung kann vorzugsweise in monolithischen Mehrkanalempfängern eingesetzt werden, z.B. auf Basis von Siliziumphotonik-Technologien.

Ausführungsbeispiele der Erfindung werden nachfolgend anhand der Zeichnungen näher erläutert.

Es zeigen:
- Fig. 1: ein Blockschaltbild der Erfindung
- Fig. 2: eine beispielhafte detaillierte Ausführungsform der Erfindung
- Fig. 3: eine alternative Ausführungsform der erfindungsgemäßen Schaltung mit Differenzspannungsausgleichseinheit ohne Rückkopplung
- Fig. 4: eine alternative Ausführungsform der erfindungsgemäßen Schaltung mit Differenzspannungsausgleichseinheit mit Rückkopplung

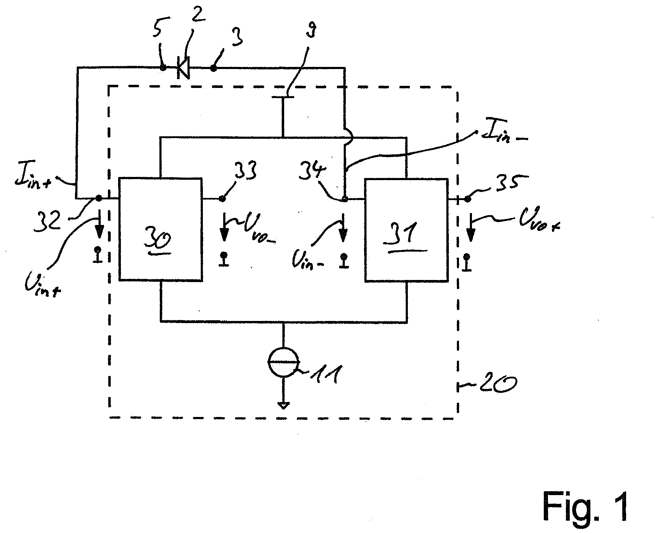

Die erfindungsgemäße Schaltung gemäß Figur 1 umfasst einen Transimpedanzverstärker 20, der über ein erstes Verstärkerteil 30 und ein zweites Verstärkerteil 31 verfügt. Das erste Verstärkerteil 30 und das zweite Verstärkerteil 31 sind an eine gemeinsame Versorgungsspannung 9 angeschlossen. Zur Einstellung eines Arbeitspunktes sind der erste Verstärkerteil 30 und der zweite Verstärkerteil 31 jeweils an dieselbe bzw. gemeinsame Stromquelle 11 angeschlossen. Die Schaltung 20 ist als ein Transimpedanzverstärker ausgebildet.

Der erste Verstärkerteil 30 weist einen ersten Eingangsanschluss 32 auf, an dem eine erste Eingangsspannung Uᵢₙ₊ anliegt und in den ein erster Eingangsstrom Iᵢₙ₊ fließt. Ferner weist der erste Verstärkerteil 30 einen ersten Ausgangsanschluss 33 auf, an dem die Ausgangsspannung Uᵥₒ₋ anliegt.

Der zweite Verstärkerteil 31 weist einen zweiten Eingangsanschluss 34 auf, an dem eine zweite Eingangsspannung Uᵢₙ₋ anliegt und in den ein zweiter Eingangsstrom Iᵢₙ₋ fließt. Ferner weist der zweite Verstärkerteil 31 einen zweiten Ausgangsanschluss 35 auf, an dem die zweite Ausgangsspannung Uᵥₒ₊ anliegt.

Nach einer nicht dargestellten alternativen Ausführungsform der Schaltung 20 kann die Stromquelle 11 entfallen, so dass der erste Verstärkerteil 30 und der zweite Verstärkerteil 31 jeweils an einem Masseanschluss angeschlossen sind. Der Entfall der Stromquelle 11 ist für solche Einsatzfälle vorteilhaft, in denen die Schaltung mit einer relativ geringen Versorgungsspannung betrieben wird. Nachteilig ist der höhere Versorgungsspannungsdurchgriff (niedrigere Power Supply Rejection Ratio, PSRR).

Der erste Verstärkerteil 30 und der zweite Verstärkerteil 31 können jeweils als einstufige oder mehrstufige Transistoranordnung ausgebildet sein. Vorzugsweise weisen sie die gleichen Transistoren bzw. Anzahl von Transistoren auf. Der erste Verstärkerteil 30 und der zweite Verstärkerteil 31 sind jeweils so ausgebildet, dass die erste Ausgangsspannung Uᵥₒ₋ proportional zu dem ersten Eingangsstrom Iᵢₙ₊ und die zweite Ausgangsspannung Uᵥₒ₊ proportional zu dem zweiten Eingangsstrom Iᵢₙ₋ ist. Vorteilhaft wird hierdurch ein Transimpedanzverstärker bereitgestellt, der im Vergleich zu dem in der US 5 345 073 A beschriebenen Transimpedanzverstärker ein wesentlich geringeres Rauschen und eine kleinere Versorgungsspannung aufweist. Die Schaltung 20 kann auch als reiner Spannungsverstärker ohne angeschlossenen Sensor genutzt werden. Alternativ kann an den Eingängen 32, 34 des ersten Verstärkerteils 30 und des zweiten Verstärkerteils 31 ein Sensor oder ein Detektor, beispielsweise ein Hallsensor oder eine Fotodiode, angeschlossen werden. In Figur 1 ist beispielhaft die Fotodiode 2 zwischen dem ersten Eingangsanschluss 32 des ersten Verstärkerteils 30 und dem zweiten Eingangsanschluss 34 des zweiten Verstärkerteils 31 angeschlossen.

Der Sensor 2 ist mit einem ersten Anschluss direkt an den Eingang 32 des ersten Verstärkerteils 30 und mit einem zweiten Anschluss an den Eingang 34 des zweiten Verstärkerteils 31 angeschlossen. Vorzugsweise wird der Sensor 2 mit symmetrischen elektrischen Eigenschaften eingesetzt, um ein bestes Ergebnis des Transimpedanzverstärkers zu erzielen. Hierzu weisen die Eingangsanschlüsse 32, 34 der Verstärkerteile 30, 31 gleiche Eigenschaften und Ladebedingungen auf. Alternativ funktioniert die Schaltung 20 auch mit asymmetrischen elektrischen Eigenschaften.

In einer weiteren Ausgestaltung der Erfindung kann der Sensors 2 nur an einen Eingang, d.h. nur an Eingang 32 des ersten Verstärkerteils 30 oder den Eingang 34 des zweiten Verstärkerteils 31 angeschlossen werden. Der jeweils andere Eingang bleibt dann z.B. unbeschaltet. In diesem Fall wird der Sensor nicht symmetrisch betrieben, und der Transimpedanzverstärker 20 liefert ein differentielles Ausgangssignal, das proportional zum Sensorstrom ist. Weiterhin können auch zwei Sensoren 2 an die Eingänge 32, 34 derart angeschlossen werden, so dass der eine Sensor 2 an den Eingang 32 des ersten Verstärkerteils 30 und der andere Sensor 2 an den Eingang 34 des zweiten Verstärkerteils 31 angeschlossen wird. Der Transimpedanzverstärker 20 gibt dann eine differentielle Spannung aus, die proportional zur Differenz der Sensorströme ist.

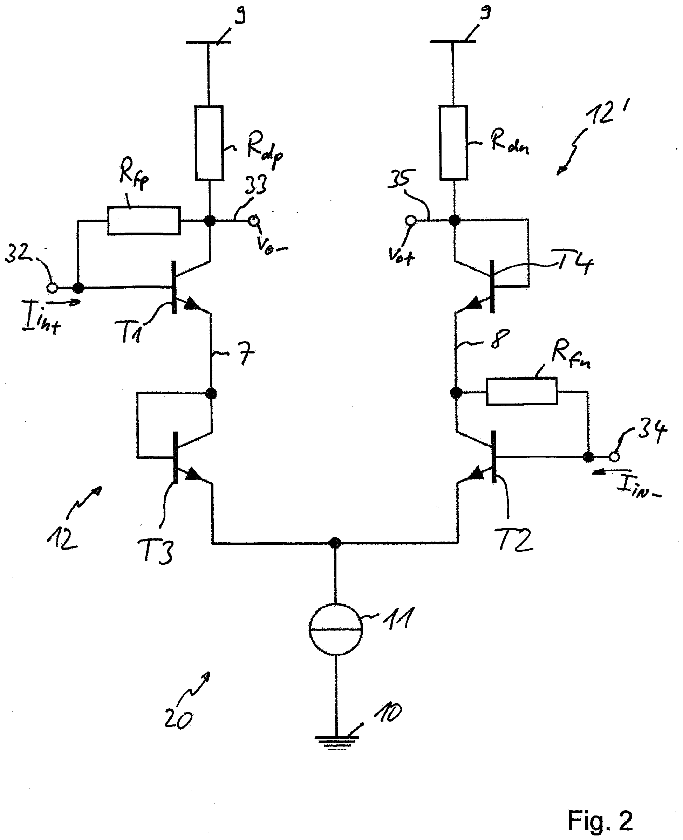

Eine mögliche detaillierte Ausgestaltung des Transimpedanzverstärkers 20 ist in Figur 2 dargestellt. Der Transimpedanzverstärker 20 weist zwei parallele Stromzweige 7, 8 auf, die sich zwischen einem Versorgungsspannungsanschluss 9 und einem Masseanschluss 10 erstrecken. Massenanschlussseitig ist eine Stromquelle 11 vorgesehen.

Ein erster Stromzweig 7 weist einen ersten Verstärkungstransistor T1 auf, der als ein npn-Transistor ausgebildet ist. Der erste Verstärkungstransistor T1 weist einen Kollektor auf, der über den Widerstand R_{fp} mit dem positiven Eingangsanschluss 32 des Transimpedanzverstärkers 20 und über einen Widerstand R_{dp} mit der Versorgungsspannung verbunden ist. Eine Basis des Verstärkungstransistors T1 ist direkt mit dem positiven Eingangsanschluss 32 verbunden. In einem zweiten Stromzweig 8 ist ein zweiter Verstärkungstransistor T2 angeordnet, der ebenfalls als npn-Transistor ausgebildet ist. Dieser Verstärkungstransistor T2 weist einen Kollektor auf, der über den Widerstand R_{fn} mit dem negativen Eingangsanschluss 34 des Transimpedanzverstärkers 20 verbunden ist. Eine Basis des Verstärkungstransistors T2 ist ebenfalls mit dem negativen Eingangsanschluss 34 verbunden. Die Verstärkungstransistoren T1 und T2 bilden einen Differenzverstärker. Wenn die Widerstände R_{fn} und R_{fp} , sowie die Widerstände R_{dp} und R_{dn} paarweise gleich sind, stellt der Wert R_{fn} = R_{fp} = R_{f} näherungsweise die Verstärkung bzw. Transimpedanz Z dar, um die ein Eingangsstrom Iᵢₙ verstärkt wird zu einer Ausgangsspannung Uₒ. Der Eingangsstrom Iᵢₙ ergibt sich als Differenz aus dem Eingangsstrom Iᵢₙ₊ und Iᵢₙ₋. Die Ausgangsspannung Uₒ ergibt sich aus der Differenz der Spannung Uᵥₒ₊ und Uᵥₒ₋ zuzüglich einer konstanten Offsetspannung.

Zusätzlich weist der Transimpedanzverstärker 20 im ersten Stromzweig 7 ein Arbeitspunktanpassungsteil 12 zur Anpassung der Eingangs- und Ausgangsspannungen von Verstärkungstransistor T1 auf. Gleichzeitig wird durch Anpassung der Arbeitspunktspannung am Eingang von Verstärkungstransistor T1 die Arbeitspunktspannung an der Kathode 5 der Fotodiode 2 eingestellt. Im vorliegenden Ausführungsbeispiel wird eine Germaniumfotodiode angenommen, bei der der gewünschte Arbeitspunkt eine Sperrspannung von ca. 1 V ist. Das Arbeitspunktanpassungsteil 12 weist zu diesem Zweck einen Transistoren T3 auf, der in Diodenverbindung, d.h. Kurzschluss von Basis und Kollektor geschaltet ist. In dem ersten Stromzweig 7 ist ein erster Transistor T3 in Diodenverbindung angeordnet, wobei ein Kollektor des Transistors T3 mit einem Emitter des Verstärkungstransistors T1 verbunden ist. Ein Emitter des Transistors T3 ist mit der Stromquelle 11 verbunden.

Des Weiteren weist der Transimpedanzverstärker 20 im zweiten Stromzweig 8 ein Arbeitspunktanpassungsteil 12' zur Anpassung der Eingangs- und Ausgangsspannungen von Verstärkertransistor T2 auf. Gleichzeitig wird durch Anpassung der Arbeitspunktspannung am Eingang von Verstärkungstransistor T2 die Arbeitspunktspannung an der Anode 3 der Fotodiode 2 eingestellt. Das Arbeitspunktanpassungsteil 12' weist zu diesem Zweck einen Transistor T4 im zweiten Stromzweig 8 auf, der in Diodenverbindung, d.h. mit Kurzschluss von Basis und Kollektor geschaltet ist. Dabei wird ein Emitter von Transistor T4 mit dem Kollektor des Verstärkungstransistors T2 und Kollektor und Basis des Transistors T4 über einen Widerstand R_{dn} mit dem Versorgungsanschluss 9 verbunden.

Der Kollektor des Transistors T1 ist über den Widerstand R_{dp} mit dem Versorgungsanschluss 9 verbunden. Die Transistoren T1, T2 ermöglichen die Verstärkung des eingangsseitigen Differenzsignals Iᵢₙ = Iᵢₙ₊ - Iᵢₙ₋ zu einer Ausgangsspannung Uₒ mit der Verstärkung R_{f}, wobei zusätzlich eine konstante Offsetspannung in Uₒ enthalten ist. Die Transistoren T3, T4 bewirken einen Offset der differentiellen Eingangs- und Ausgangsspannung, der von der gewünschten Arbeitspunktspannung der Fotodiode 2 abhängig ist.

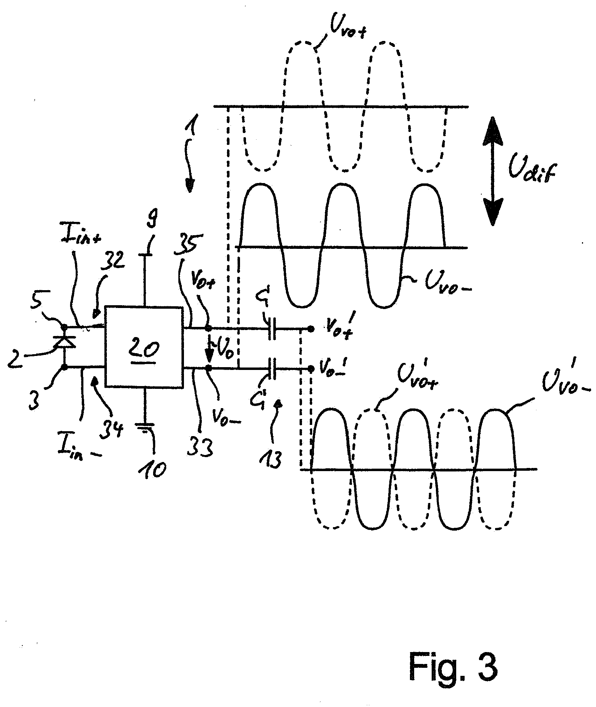

Der Offset der differentiellen Ausgangsspannung ist in Figur 3 dargestellt. An den Ausgangsklemmen Vₒ₊ bzw. Vₒ₋ 35,33 der in Figur 3 dargestellten Schaltung liegen die Spannungen Uᵥₒ₊ bzw. Uᵥₒ₋ an, die einen unterschiedlichen Gleichanteil aufweisen und betragsmäßig gleiche Wechselanteile aufweisen, so dass die differentiellen Ausgangsspannung Uₒ = Uᵥₒ₊ - Uᵥₒ₋ eine konstante Offsetspannung aufweist.

Eine weitere Ausgestaltung der Erfindung zur Eliminierung des Offsets der differentiellen Ausgangsspannung Uₒ ist in Figur 3 gezeigt. Sie umfasst einen Transimpedanzverstärker 20, der eingangsseitig symmetrisch an eine Fotodiode 2 angeschlossen ist. Eine Anode 3 der Fotodiode 2 ist an einem negativen Eingangsanschluss 34 des Transimpedanzverstärkers 20 und eine Kathode 5 der Fotodiode 2 mit einem positiven Eingangsanschluss 32 des Transimpedanzverstärkers 20 verbunden. Der Transimpedanzverstärker 20 weist einen positiven Ausgangsanschluss 35 bzw. Vₒ₊ und einen negativen Ausgangsanschluss 33 bzw. Vₒ₋ auf, wie aus Figur 3 ersichtlich ist. Diese beiden Spannungen sind um 180° phasenverschoben und weisen einen unterschiedlichen Gleichspannungsanteil auf, so dass sich eine Offset-Spannung U_{dif} ergibt. Typischerweise ist U_{dif} konstant oder ändert sich nur langsam. Um die Offset-Spannung U_{dif} auf null zu reduzieren, ist eine Differenz-Spannungsausgleichseinheit 13 gemäß Figur 3 vorgesehen, mittels derer die Offset-Spannung bzw. die Gleichspannungsdifferenz U_{dif} zwischen dem positiven Ausgangsanschluss Vₒ₊ und dem negativen Ausgangsanschluss Vₒ₋ des Transimpedanzverstärkers 20 auf Null reduziert wird. Diese Differenz-Spannungsausgleicheinheit 13 ist als ein passives Hochpassfilter ausgebildet, das Kapazitäten C aufweist, die jeweils an den Ausgangsanschlüssen Vₒ₊, Vₒ₋angeschlossen sind, so dass sich an den modifizierten Ausgangsanschlüssen Vₒ₊' und Vₒ₋' Ausgangssignale Uᵥₒ₊' und Uᵥₒ₋' ergeben, die im Vergleich zu den an den Ausgangsanschlüssen Vₒ₊, Vₒ₋ anliegenden Spannungen Uᵥₒ₊, Uᵥₒ₋ den gleichen Gleichspannungsanteil aufweisen.

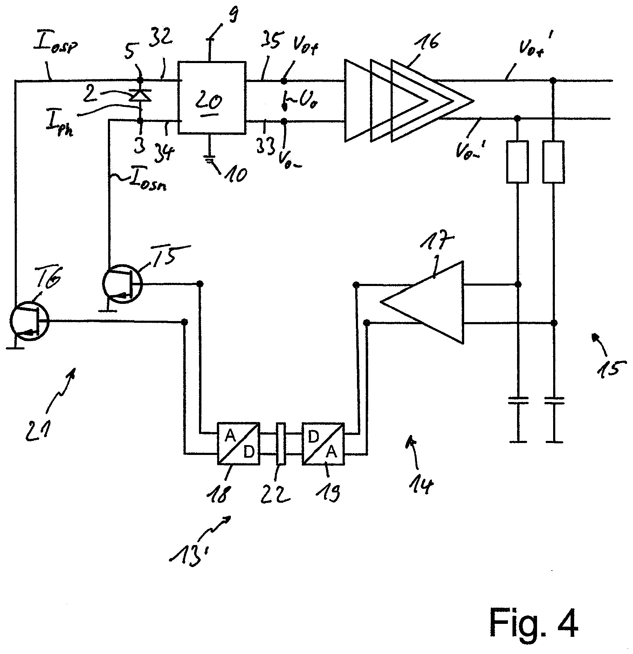

Nach einer alternativen Ausführungsform gemäß Figur 4 kann eine Differenzspannungsausgleichseinheit 13' vorgesehen sein, die durch ein Rücckopplungsschaltungs-Teil 14 gebildet ist. Dieses Rückkopplungsschaltungs-Teil 14 weist einen differentiellen Tiefpassfilter 15 auf, der direkt an dem Transimpedanzverstärker 20 oder an ausgangsseitig des Transimpedanzverstärkers 20 angeordneten weiteren Verstärkerstufen 16 angeschlossen ist. Im Rückkopplungszweig schließt sich an den Tiefpassfilter 15 ein Fehlerkorrekturverstärker 17 an. An den Fehlerkorrekturverstärker 17 schließt sich ein A/D-Wandler 19, ein Register 22, sowie ein D/A-Wandler 18 an. Ausgangsseitig des D/A-Wandlers 19 ist ein Transistorschaltungs-Teil 21 vorgesehen, das aus zwei Transistoren T5, T6 besteht.

Kollektoranschlüsse der Transistoren T5, T6 sind jeweils an den negativen Eingangsanschluss 34 bzw. positiven Eingangsanschluss 32 des Transimpedanzverstärkers 20 angeschlossen. Im Betriebszustand fließen Kollektorströme Iₒₛₚ, Iₒₛₙ der Transistoren T5, T6 zu den Eingangsanschlüssen 34 bzw. 32 und ein Strom Iₚₕ durch die Fotodiode 2.. Durch das Rückkopplungsschaltungs-Teil 14 ergibt sich mittels eines sich einstellenden Offsetstroms eine Änderung des Gleichanteils des Eingangsstrom Iᵢₙ an dem Transimpendanzverstärker 20, der bewirkt, dass die Ausgangspannungssignale Uᵥₒ₊' und Uᵥₒ₋' die gleichen Gleichspannungsanteile aufweisen. Ein Vorteil der Verwendung von A/D-Wandler 19, Register 22 und D/A-Wandler 18 ist, dass der Takt des Registers 22 je nach Bedarf ein- oder ausgeschaltet werden kann. Wird der Takt eingeschaltet, werden die Ströme Iₒₛₚ und Iₒₛₙ genau und kontinuierlich nachgestellt. Wird der Takt dagegen ausgeschaltet, werden die zuletzt gefundenen Einstellungen für die Ströme Iₒₛₚ und Iₒₛₙ beibehalten und ändern sich nicht mehr. Dies kann vorteilhaft sein, wenn z.B. das dynamische Regelverhalten des Rückkopplungsschaltungsteils 14 das Ausgangssignal des Transimpedanzverstärkers 20 ungünstig beeinflusst. In diesem Fall kann eine feste Einstellung der Iₒₛₚ und Iₒₛₙ erforderlich sein.

Nach einer alternativen nicht dargestellten Ausführungsform der Erfindung können der A/D-Wandler 19, Register 22 und der D/A-Wandler 18 weggelassen werden und die Ausgänge des Fehlerkorrekturverstärkers 17 direkt mit den Eingängen der Transistoren T5 und T6 verbunden werden.

Es versteht sich, dass die genannten Transistoren T1, T2, T3, T4, T5, T6 auch andere Arten als Bipolartransistoren, beispielsweise Feldeffekttransistoren, ausgebildet sein können. Obwohl in den hierin beschriebenen Ausführungsformen die Bipolartransistoren vorgesehen sind, leuchtet es dem Fachmann ein, dass beliebige der Bipolartransistoren in alternativen Ausführungsformen durch eine Vielfalt anderer Arten von Transistoren, wie zum Beispiel Feldeffekttransistoren, ersetzt werden können. In dieser Hinsicht entsprechen Emitter-, Kollektor- und Basisanschlüsse der hier beschriebenen Bipolartransistoren in Ausführungsformen, die Feldeffekttransistoren umfassen, Source-, Drain- bzw. Gate-Anschlüsse und können beim Beschreiben der Ausführungsform austauschbar verwendet werden. Die Verwendung der Begriffe Emitter-, Kollektor- und Basisanschlüsse wirkt sich demgemäß nicht begrenzend auf Ausführungsformen bzw. der Erfindung aus. Desgleichen leuchtet es dem Fachmann ein, dass, bei geeigneter Einstellung der Arbeitspunktspannungen und -ströme der Transistoren auch pnp-Transistoren, statt npn-Transistoren, bzw. statt n-Feldeffekttranistoren auch p-Feldeffekttransistoren verwendet werden können.

Die hierin abgebildeten Blockschaltbilder sind nur ein Beispiel. Viele Abwandlungen dieser Blockschaltbilder oder der hierin beschriebenen Operationen sind möglich, ohne vom Geist der Erfindung abzuweichen. Zum Beispiel können die Schaltungen in einer anderen Reihenfolge angeordnet sein oder können Schaltungen hinzugefügt, gelöscht oder geändert werden. Alle diese Abwandlungen werden als Bestandteil der beanspruchten Erfindung angesehen.

In einer weiteren Ausführungsform können die durch die Verstärkungstransistoren T1 und T2 gebildeten Verstärker auch jeweils durch mehrstufige Verstärkerschaltungen ersetzt werden. Dies kann z.B. eine höhere Bandbreite ermöglichen.

In einer weiteren Ausführungsform können die Arbeitspunktanpassungsteile 12 und 12' auch durch V_{BE}-Multiplizierer (siehe z.B. "VBE-Multiplier", in Crecraft, David; Gergely, Stephen (May 21, 2002). Analog Electronics. Butterworth-Heinemann. p. 188. ISBN 0080475833) gebildet werden. Vorteilhaft ist beim V_{BE}-Multiplizierern im Vergleich zu Dioden, dass damit Spannungen erzeugt werden können die k*V_{BE} betragen, wobei k nicht ganzzahlig sein muss.

## Patentansprüche

1. Schaltung enthaltend einen Transimpedanzverstärker (20) zur Umsetzung zweier Eingangsströme (Iᵢₙ₊, Iᵢₙ₋) in zwei Ausgangsspannungen (Uᵥₒ₋, Uᵥₒ₊) mit einem ersten Stromzweig (7) enthaltend einen ersten Eingang (32), an dem eine erste Eingangsspannung (Uᵢₙ₊) anliegt und in den ein erster Eingangsstrom (Iᵢₙ₊) fließt, und mit einem zweiten Stromzweig (8) enthaltend einen zweiten Eingang (34), an dem eine zweite Eingangsspannung (Uᵢₙ) anliegt und in den ein zweiter Eingangsstrom (Iᵢₙ₋) fließt, wobei der erste Stromzweig (7) und der zweite Stromzweig (8) an eine gemeinsame Versorgungsspannung (9) an einem Versorgungsanschluss angeschlossen sind,
wobei der erste Stromzweig (7) und der zweite Stromzweig (8) an eine gemeinsame Stromquelle (11) angeschlossen sind,
wobei der erste Eingang (32) und der zweite Eingang (34) eine unterschiedliche Gleichspannung aufweisen
wobei der erste Stromzweig (7) und der zweite Stromzweig (8) derart ausgebildet sind, dass eine Ausgangsspannung (Uᵥₒ₋) des ersten Stromzweigs (7) proportional zu dem ersten Eingangsstrom (Iᵢₙ₊) des ersten Stromzweigs (7) und eine Ausgangsspannung (Uᵥₒ₊) des zweiten Stromzweigs (8) proportional zu dem zweiten Eingangsstrom (Iᵢₙ₋) des zweiten Stromzweigs (8) ist,
wobei ein Sensor (2) direkt mit dem ersten und zweiten Eingang (32, 34) verbunden ist,
wobei die zwei parallelen Stromzweige (7, 8) jeweils eine Anzahl von Transistoren (T1, T2, T3, T4) aufweisen,
wobei sich die Stromzweige (7, 8) zwischen dem Versorgungsanschluss und einem ersten Anschluss der Stromquelle (11) erstrecken, wobei ein zweiter Anschluss der Stromquelle mit der Masse verbunden ist,
wobei ein erster Anschluss (3) des Sensors (2) mit einem Basisanschluss eines in dem ersten Stromzweig (7) angeordneten ersten Verstärkungstransistors (T1) und über einen ersten Widerstand (R_{fp}) mit einem Kollektoranschluss des ersten Verstärkungstransistors (T1) verbunden ist,
wobei der Kollektor des ersten Verstärkungstransistors (T1) über einen dritten Widerstand (R_{dp} ) mit der Versorgungsspannung verbunden ist,
wobei ein zweiter Anschluss (5) des Sensors (2) mit einem Basisanschluss eines in dem zweiten Stromzweig (8) angeordneten zweiten Verstärkungstransistors (T2) und über einen zweiten Widerstand (R_{fn}) mit einem Kollektoranschluss des zweiten Verstärkertransistors (T2) verbunden ist,
wobei im ersten Stromzweig (7) ein erstes Arbeitspunktanpassungsteil (12) zur Anpassung der Eingangs- und Ausgangsspannungen des ersten Verstärkungstransistors (T1) vorgesehen ist, das zwischen dem Emitter des ersten Verstärkungstransistors (T1) und dem ersten Anschluss der Stromquelle (11) angeordnet ist, wobei durch die Anpassung der Arbeitspunktspannung am Eingang des ersten Verstärkungstransistors (T1) gleichzeitig die Arbeitspunktspannung am zweiten Anschluss (5) des Sensors (2) eingestellt wird,
wobei im zweiten Stromzweig (8) ein zweites Arbeitspunktanpassungsteil (12') zur Anpassung der Eingangs- und Ausgangsspannungen des zweiten Verstärkertransistors (T2) vorgesehen ist, das zwischen dem Kollektor des zweiten Verstärkungstransistors (T2) und einem ersten Anschluss eines vierten Widerstandes (R_{dn} ) angeschlossen ist, der an seinem zweiten Anschluss mit der Versorgungsspannung (9) verbunden ist, wobei durch die Anpassung der Arbeitspunktspannung am Eingang des zweiten Verstärkungstransistors (T2) gleichzeitig die Arbeitspunktspannung am ersten Anschluss (3) des Sensors (2) eingestellt wird, und
wobei der erste Widerstand (Rfp) und der zweite Widerstand (Rfn) gleich sind einerseits und wobei der dritte Widerstand (Rdp) und der vierte Widerstand (Rdn) gleich sind andererseits und
wobei der erste und der zweite Verstärkungstransistor (T1 und T2) einen Differenzverstärker bilden.

2. Schaltung nach Anspruch 1, **dadurch gekennzeichnet, dass** die Stromquelle (11) durch einen Kurzschluss ersetzt wird.

3. Schaltung nach einem der Ansprüche 1 bis 2, **dadurch gekennzeichnet, dass** der erste Stromzweig (7) und der zweite Stromzweig (8) als eine einstufige oder mehrstufige Transistoranordnung ausgebildet sind.

4. Schaltung nach einem der Ansprüche 1 bis 3, **dadurch gekennzeichnet, dass** ein Sensor (2), insbesondere eine Fotodiode, mit einem ersten Anschluss direkt an dem ersten Eingang (32) des ersten Stromzweigs (7) und mit einem zweiten Anschluss direkt an dem zweiten Eingang (34) des zweiten Stromzweigs (8) angeschlossen ist.

5. Schaltung nach einem der Ansprüche 1 bis 4, **dadurch gekennzeichnet, dass** der erste Stromzweig (7) und der zweite Stromzweig (8) die gleichen Transistoren und/oder die gleiche Anzahl von Transistoren aufweisen.

6. Schaltung nach einem der Ansprüche 1 bis 5, **dadurch gekennzeichnet, dass** das erste Arbeitspunktanpassungsteil (12) einen Transistor (T3) mit Kurzschluss zwischen der Basis und dem Kollektor desselben aufweist und dass das zweite Arbeitspunktanpassungsteil (12') ebenfalls einen Transistor (T4) mit Kurzschluss zwischen der Basis und dem Kollektor desselben aufweist.

7. Schaltung nach einem der Ansprüche 1 bis 6, **dadurch gekennzeichnet, dass** eine Anzahl von Transistoren (T5) des ersten Arbeitspunktanpassungsteils (12) in Abhängigkeit von einer Arbeitspunktspannung des Sensors (2) vorgesehen ist.

8. Schaltung nach einem der Ansprüche 1 bis 7, **dadurch gekennzeichnet, dass** eine Anzahl von Transistoren (T6) des zweiten Arbeitspunktanpassungsteils (12') zum symmetrischen Betrieb der Gesamtschaltung vorgesehen ist.

9. Schaltung nach einem der Ansprüche 1 bis 8, **dadurch gekennzeichnet, dass** ein positiver Ausgangsanschluss (35, Vₒ₊) des Transimpedanzverstärkers (20) mit einem Kollektoranschluss des zweiten Arbeitspunktanpassungsteils (12', T4) und ein negativer Ausgangsanschluss (33, Vₒ₋) des Transimpedanzverstärkers (20) mit einem Kollektoranschluss des ersten Verstärkungstransistors (T1) verbunden ist.

10. Schaltung nach einem der Ansprüche 1 bis 9, **dadurch gekennzeichnet, dass** an Ausgangsanschlüssen (35, 33; Vₒ₊, Vₒ₋) des Transimpedanzverstärkers (20) eine Anzahl von Verstärkerstufen (16) angeschlossen ist mit einem positiven Ausgangsanschluss (Vₒ₊') und mit einem negativen Ausgangsanschluss (Vₒ₋').

11. Schaltung nach einem der Ansprüche 1 bis 10, **dadurch gekennzeichnet, dass** an den Ausgangsanschlüssen (35, 33 ; Vₒ₊, Vₒ₋) des Transimpedanzverstärkers (20) oder der Verstärkerstufen (16) eine Differenz-Spannungsausgleichseinheit (13, 13') vorgesehen ist, mittels derer eine Gleichspannungsdifferenz (U_{dif}) zwischen der Spannung (Uᵥₒ₊) am positiven Ausgangsanschluss (35, Vₒ₊) und einer Spannung (Uᵥₒ₋) am negativen Ausgangsanschluss (Vₒ₋, 33) des Transimpedanzverstärkers (20) auf Null reduziert wird.

12. Schaltung nach Anspruch 11, **dadurch gekennzeichnet, dass** die Differenz-Spannungsausgleichseinheit (13) durch ein differentielles, passives Hochpassfilter gebildet ist, das durch jeweils an den Ausgangsanschlüssen (33, 35; Vₒ₊, Vₒ₋) des Transimpedanzverstärkers (20) angeschlossene Kapazitäten (C) gebildet ist.

13. Schaltung nach Anspruch 11, **dadurch gekennzeichnet, dass** die Differenz-Spannungsausgleichseinheit (13') durch ein Rücckopplungsschaltungs-Teil (14) gebildet ist, das mehrere in Reihe geschaltete Komponenten umfasst:
- einen differentiellen Tiefpassfilter (15), der mit den Ausgangsanschlüssen (33, 35; Vₒ₊, Vₒ₋) des Transimpedanzverstärkers (20) oder der Verstärkerstufen (16, Vₒ₊', Vₒ₋') verbunden ist,
- einen Fehlerkorrekturverstärker (17),
- ein Transistorschaltungs-Teil (21), das mit einem ersten Anschluss (3) und einem zweiten Anschluss (5) eines Sensors (2) derart verbunden ist, dass eine am Ausgang (33, 35) des Transimpedanzverstärkers (20) anliegende differentielle Gleichspannung zu Null wird.

14. Schaltung nach Anspruch 13, **dadurch gekennzeichnet, dass** das Rückkopplungsschaltungs-Teil (14) zwischen Fehlerkorrekturverstärker (17) und Transistorschaltungsteil (21) eine Reihenschaltung aus A/D-Wandler (19), Register (22) und D/A-Wandler (18) aufweist.

## Claims

1. Circuit including a transimpedance amplifier (20) for converting two input currents (Iᵢₙ₊, Iᵢₙ₋) into two output voltages (Uᵥₒ₋, Uᵥₒ₊), comprising a first current branch (7) containing a first input (32) to which a first input voltage (Uᵢₙ₊) is applied and into which a first input current (Iᵢₙ₊) flows, and comprising a second current branch (8) containing a second input (34) to which a second input voltage (Uᵢₙ₋) is applied and into which a second input current (Iᵢₙ₋) flows, wherein the first current branch (7) and the second current branch (8) are connected to a common supply voltage (9) at a supply terminal,
wherein the first current branch (7) and the second current branch (8) are connected to a common current source (11),
wherein the first input (32) and the second input (34) have a different DC voltage,
wherein the first current branch (7) and the second current branch (8) are configured in such a way that an output voltage (Uᵥₒ₋) of the first current branch (7) is proportional to the first input current (Iᵢₙ₊) of the first current branch (7) and an output voltage (Uᵥₒ₊) of the second current branch (8) is proportional to the second input current (Iᵢₙ₋) of the second current branch (8),
wherein a sensor (2) is connected directly to the first and second input (32, 34),
wherein the two parallel current branches (7, 8) each have a number of transistors (T1, T2, T3, T4),
wherein the current branches (7, 8) extend between the supply terminal and a first terminal of the current source (11), wherein a second terminal of the current source is connected to earth,
wherein a first terminal (3) of the sensor (2) is connected to a base terminal of a first amplification transistor (T1) arranged in the first current branch (7), and via a first resistor (R_{fp}) to a collector terminal of the first amplification transistor (T1),
wherein the collector of the first amplification transistor (T1) is connected via a third resistor (R_{dp}) to the supply voltage,
wherein a second terminal (5) of the sensor (2) is connected to a base terminal of a second amplification transistor (T2) arranged in the second current branch (8), and via a second resistor (R_{fn}) to a collector terminal of the second amplifier transistor (T2),
wherein, in the first current branch (7), a first operating point adjustment section (12) is provided for adjusting the input and output voltages of the first amplification transistor (T1), said section being arranged between the emitter of the first amplification transistor (T1) and the first terminal of the current source (11), wherein the operating point voltage at the second terminal (5) of the sensor (2) is set at the same time by adjusting the operating point voltage at the input of the first amplification transistor (T1),
wherein, in the second current branch (8), a second operating point adjustment section (12') is provided for adjusting the input and output voltages of the second amplifier transistor (T2), said section being connected between the collector of the second amplification transistor (T2) and a first terminal of a fourth resistor (R_{dn}) which is connected at its second terminal to the supply voltage (9), wherein the operating point voltage at the first terminal (3) of the sensor (2) is set at the same time by adjusting the operating point voltage at the input of the second amplification transistor (T2), and
wherein on the one hand the first resistor (R_{fp}) and the second resistor (R_{fn}) are identical and wherein on the other hand the third resistor (R_{dp}) and the fourth resistor (R_{dn}) are identical and
wherein the first and the second amplification transistor (T1 and T2) form a differential amplifier.

2. Circuit according to Claim 1, **characterized in that** the current source (11) is replaced by a short circuit.

3. Circuit according to one of Claims 1 to 2, **characterized in that** the first current branch (7) and the second current branch (8) are configured as a one-stage or multistage transistor arrangement.

4. Circuit according to one of Claims 1 to 3, **characterized in that** a sensor (2), in particular a photodiode, is connected via a first terminal directly to the first input (32) of the first current branch (7), and via a second terminal directly to the second input (34) of the second current branch (8).

5. Circuit according to one of Claims 1 to 4, **characterized in that** the first current branch (7) and the second current branch (8) comprise the same transistors and/or the same number of transistors.

6. Circuit according to one of Claims 1 to 5, **characterized in that** the first operating point adjustment section (12) comprises a transistor (T3) having a short circuit between the base and the collector of the same, and the second operating point adjustment section (12') also comprises a transistor (T4) having a short circuit between the base and the collector of the same.

7. Circuit according to one of Claims 1 to 6, **characterized in that** a number of transistors (T5) of the first operating point adjustment section (12) are provided as a function of an operating point voltage of the sensor (2).

8. Circuit according to one of Claims 1 to 7, **characterized in that** a number of transistors (T6) of the second operating point adjustment section (12') are provided for the symmetrical operation of the overall circuit.

9. Circuit according to one of Claims 1 to 8, **characterized in that** a positive output terminal (35, Vₒ₊) of the transimpedance amplifier (20) is connected to a collector terminal of the second operating point adjustment section (12', T4), and a negative output terminal (33, Vₒ₋) of the transimpedance amplifier (20) is connected to a collector terminal of the first amplification transistor (T1).

10. Circuit according to one of Claims 1 to 9, **characterized in that**, at output terminals (35, 33; Vₒ₊, Vₒ₋) of the transimpedance amplifier (20), a number of amplifier stages (16) are connected to a positive output terminal (V_{o+'}) and to a negative output terminal (V_{o-'}).

11. Circuit according to one of Claims 1 to 10, **characterized in that**, at the output terminals (35, 33; Vₒ₊, Vₒ₋) of the transimpedance amplifier (20) or the amplifier stages (16), a differential voltage balancing unit (13, 13') is provided, by means of which a DC-voltage difference (U_{dif}) between the voltage (Uᵥₒ₊) at the positive output terminal (35, Vₒ₊) and a voltage (Uᵥₒ₋) at the negative output terminal (Vₒ₋, 33) of the transimpedance amplifier (20) is reduced to zero.

12. Circuit according to Claim 11, **characterized in that** the differential voltage balancing unit (13) is formed by a differential, passive high-pass filter which is formed by capacitors (C) connected to the respective output terminals (33, 35; Vₒ₊, Vₒ₋) of the transimpedance amplifier (20).

13. Circuit according to Claim 11, **characterized in that** the differential voltage balancing unit (13') is formed by a feedback circuit section (14) which comprises several components connected in series:
- a differential low-pass filter (15) which is connected to the output terminals (33, 35; Vₒ₊, Vₒ₋) of the transimpedance amplifier (20) or the amplifier stages (16, V_{o+'}, V_{o-'}),
- an error correction amplifier (17),
- a transistor circuit section (21) which is connected to a first terminal (3) and a second terminal (5) of a sensor (2) in such a way that a differential DC voltage which is present at the output (33, 35) of the transimpedance amplifier (20) goes to zero.

14. Circuit according to Claim 13, **characterized in that** the feedback circuit section (14) between the error correction amplifier (17) and the transistor circuit section (21) comprises a series circuit made up of an A/D converter (19), a register (22), and a D/A converter (18) .

## Revendications

1. Circuit, comprenant un amplificateur à transimpédance (20) pour convertir deux courants d'entrée (Iᵢₙ₊, Iᵢₙ₋) en deux tensions de sortie (U_{VO-}, U_{VO+}), pourvu d'une première branche de courant (7) comprenant une première entrée (32) à laquelle est appliquée une première tension d'entrée (Uᵢₙ₊) et dans laquelle circule un premier courant d'entrée (Iᵢₙ₊), et pourvu d'une deuxième branche de courant (8) comprenant une deuxième entrée (34) à laquelle est appliquée une deuxième tension d'entrée (Uᵢₙ₋) et dans laquelle circule un deuxième courant d'entrée (Iᵢₙ₋), dans lequel la première branche de courant (7) et la deuxième branche de courant (8) sont connectées à une tension d'alimentation commune (9) au niveau d'une borne d'alimentation,
dans lequel la première branche de courant (7) et la deuxième branche de courant (8) sont connectées à une source de courant commune (11),
dans lequel la première entrée (32) et la deuxième entrée (34) présentent une tension continue différente,
dans lequel la première branche de courant (7) et la deuxième branche de courant (8) sont réalisées de telle sorte qu'une tension de sortie (U_{VO-}) de la première branche de courant (7) est proportionnelle au premier courant d'entrée (Iᵢₙ₊) de la première branche de courant (7), et une tension de sortie (U_{VO+}) de la deuxième branche de courant (8) est proportionnelle au deuxième courant d'entrée (Iᵢₙ₋) de la deuxième branche de courant (8),
dans lequel un capteur (2) est relié directement à la première et à la deuxième entrée (32, 34),
dans lequel les deux branches de courant parallèles (7, 8) présentent respectivement un certain nombre de transistors (T1, T2, T3, T4),
dans lequel les branches de courant (7, 8) s'étendent entre la borne d'alimentation et une première borne de la source de courant (11), une deuxième borne de la source de courant étant reliée à la masse,
dans lequel une première borne (3) du capteur (2) est reliée à une borne de base d'un premier transistor d'amplification (T1) disposé dans la première branche de courant (7) et est reliée par une première résistance (R_{fp}) à une borne de collecteur du premier transistor d'amplification (T1),
dans lequel le collecteur du premier transistor d'amplification (T1) est relié par une troisième résistance (R_{dp}) à la tension d'alimentation,
dans lequel une deuxième borne (5) du capteur (2) est reliée à une borne de base d'un deuxième transistor d'amplification (T2) disposé dans la deuxième branche de courant (8) et reliée par une deuxième résistance (R_{fn}) à une borne de collecteur du deuxième transistor d'amplification (T2),
dans lequel, dans la première branche de courant (7), une première pièce d'adaptation de point de fonctionnement (12) pour adapter les tensions d'entrée et de sortie du premier transistor d'amplification (T1) est prévue qui est disposée entre l'émetteur du premier transistor d'amplification (T1) et la première borne de la source de courant (11), dans lequel l'adaptation de la tension de point de fonctionnement à l'entrée du premier transistor d'amplification (T1) règle en même temps la tension de point de fonctionnement à la deuxième borne (5) du capteur (2),
dans lequel, dans la deuxième branche de courant (8), une deuxième pièce d'adaptation de point de fonctionnement (12') pour adapter les tensions d'entrée et de sortie du deuxième transistor d'amplification (T2) est prévue qui est disposée entre le collecteur du deuxième transistor d'amplification (T2) et une première borne d'une quatrième résistance (R_{dn}) qui est reliée au niveau de sa deuxième borne à la tension d'alimentation (9), dans lequel l'adaptation de la tension de point de fonctionnement à l'entrée du deuxième transistor d'amplification (T2) règle en même temps la tension de point de fonctionnement à la première borne (3) du capteur (2), et
dans lequel la première résistance (R_{fp}) et la deuxième résistance (R_{fn}) sont identiques d'une part, et dans lequel la troisième résistance (R_{dp}) et la quatrième résistance (R_{dn}) sont identiques d'autre part, et
dans lequel le premier et le deuxième transistor d'amplification (T1 et T2) constituent un amplificateur différenciateur.

2. Circuit selon la revendication 1, **caractérisé en ce que** la source de courant (11) est remplacée par un court-circuit.

3. Circuit selon l'une quelconque des revendications 1 à 2, **caractérisé en ce que** la première branche de courant (7) et la deuxième branche de courant (8) sont réalisées sous la forme d'un agencement de transistor à un ou plusieurs étages.

4. Circuit selon l'une quelconque des revendications 1 à 3, **caractérisé en ce qu'**un capteur (2), en particulier une photodiode, est connecté(e) par une première borne directement à la première entrée (32) de la première branche de courant (7) et par une deuxième borne directement à la deuxième entrée (34) de la deuxième branche de courants (8).

5. Circuit selon l'une quelconque des revendications 1 à 4, **caractérisé en ce que** la première branche de courant (7) et la deuxième branche de courant (8) présentent les mêmes transistors et/ou le même nombre de transistors.

6. Circuit selon l'une quelconque des revendications 1 à 5, **caractérisé en ce que** la première pièce d'adaptation de point de fonctionnement (12) présente un transistor (T3) avec un court-circuit entre la base et le collecteur de celui-ci, et **en ce que** la deuxième pièce d'adaptation de point de fonctionnement (12') présente également un transistor (T4) avec un court-circuit entre la base et le collecteur de celui-ci.

7. Circuit selon l'une quelconque des revendications 1 à 6, **caractérisé en ce qu'**un certain nombre de transistors (T5) de la première pièce d'adaptation de point de fonctionnement (12) est prévu en fonction d'une tension de point de fonctionnement du capteur (2) .

8. Circuit selon l'une quelconque des revendications 1 à 7, **caractérisé en ce qu'**un certain nombre de transistors (T6) de la deuxième pièce d'adaptation de point de fonctionnement (12') est prévu pour le fonctionnement symétrique de l'ensemble du circuit.

9. Circuit selon l'une quelconque des revendications 1 à 8, **caractérisé en ce qu'**une borne de sortie positive (35, V_{O+}) de l'amplificateur à transimpédance (20) est reliée à une borne de collecteur de la deuxième pièce d'adaptation de point de fonctionnement (12', T4), et une borne de sortie négative (33, V_{O-}) de l'amplificateur à transimpédance (20) est reliée à une borne de collecteur du premier transistor d'amplification (T1).

10. Circuit selon l'une quelconque des revendications 1 à 9, **caractérisé en ce qu'**au niveau des bornes de sortie (35, 33 ; V_{O+}, V_{O-}) de l'amplificateur à transimpédance (20) est connecté un certain nombre d'étages d'amplificateur (16) avec une borne de sortie positive (V_{O+}') et avec une borne de sortie négative (V_{O-}').

11. Circuit selon l'une quelconque des revendications 1 à 10, **caractérisé en ce qu'**au niveau des bornes de sortie (35, 33 ; V_{O+} V_{O-}) de l'amplificateur à transimpédance (20) ou des étages d'amplificateur (16) est prévue une unité d'égalisation de tension différentielle (13, 13') au moyen de laquelle une différence de tension continue (U_{dif}) entre la tension (U_{VO+}) à la borne de sortie positive (35, V_{O+}) et une tension (U_{VO-}) à la borne de sortie négative (V_{O-}, 33) de l'amplificateur à transimpédance (20) est réduite à zéro.

12. Circuit selon la revendication 11, **caractérisé en ce que** l'unité d'égalisation de tension différentielle (13) est formée par un filtre passe-haut passif différentiel qui est formé par des condensateurs (C) connectées respectivement aux bornes de sortie (33, 35 ; V_{O+}, V_{O-}) de l'amplificateur à transimpédance (20) .

13. Circuit selon la revendication 11, **caractérisé en ce que** l'unité d'égalisation de tension différentielle (13') est formée par une pièce de circuit de rétroaction (14) qui comprend plusieurs composants montés en série :
- un filtre passe-bas différentiel (15) qui est relié aux bornes de sortie (33, 35 ; V_{O+}, V_{O-}) de l'amplificateur à transimpédance (20) ou des étages d'amplificateur (16, V_{O+}', V_{O-}'),
- un amplificateur de correction d'erreur (17),
- une pièce de circuit de transistor (21) qui est reliée à une première borne (3) et à une deuxième borne (5) d'un capteur (2) de telle sorte qu'une tension continue différentielle appliquée à la sortie (33, 35) de l'amplificateur à transimpédance (20) est réduite à zéro.

14. Circuit selon la revendication 13, **caractérisé en ce que** la pièce de circuit de rétroaction (14) présente entre l'amplificateur de correction d'erreur (17) et la pièce de circuit de transistor (21) un montage en série d'un convertisseur A/N (19), d'un registre (22) et d'un convertisseur N/A (18).
